Europäisches Patentamt

European Patent Office

Office européen des brevets

(19)

(11) Publication number: **0 019 396**
**B1**

(12)

# EUROPEAN PATENT SPECIFICATION

(45) Date of publication of patent specification: **02.03.83**

(51) Int. Cl.³: **H 05 K 13/04, H 01 R 43/00**

(21) Application number: **80301427.3**

(22) Date of filing: **01.05.80**

(54) **Apparatus for, and a method of, inserting tape mounted terminals into apertures in a workpiece.**

(30) Priority: **17.05.79 US 39933**

(43) Date of publication of application:
**26.11.80 Bulletin 80/24**

(45) Publication of the grant of the patent:
**02.03.83 Bulletin 83/9**

(84) Designated Contracting States:
**DE FR GB IT NL**

(56) References cited:
**DE - B - 1 815 512**
**DE - B - 2 236 309**
**US - A - 3 545 606**

(73) Proprietor: **AMP INCORPORATED**
**Eisenhower Boulevard**
**Harrisburg, Pennsylvania (US)**

(72) Inventor: **Bakermans, Johannes C.W.**
**3809 Darby Road**
**Harrisburg Pennsylvania 17109 (US)**

(74) Representative: **Terrell, Thomas Gwyn et al,**
**20 Queensmere**
**Slough, Berkshire SL1 1YZ (GB)**

Courier Press, Leamington Spa, England.

## Apparatus for, and a method of, inserting tape mounted terminals into apertures in a workpiece

There is disclosed in United States Patent Specification No. 3,545,606, apparatus for inserting into apertures in a workpiece at a terminal insertion station, electrical terminals depending in two spaced, juxtaposed rows from a flexible carrier tape, each terminal being detachably secured at one end to the tape, the apparatus comprising an assembly for releasably gripping the terminals and which can be moved towards the insertion station to insert the other ends of the terminals into the apertures.

In this known apparatus, the terminal gripping assembly is in the form of a simple clamp having grooves for receiving opposite edges of the tape and which is moved manually towards the insertion station to insert the terminals into the apertures in the workpiece which may be, for example, an electrical connector housing or a circuit board.

The present invention is intended to provide a machine to which tape mounted terminals can be fed and which will automatically strip the terminals from the tape and insert them into the apertures in a workpiece, and a method of performing these steps, which is readily susceptible to being automated.

According to one aspect of the invention apparatus as defined in the first paragraph of the present specification is characterised in that the apparatus, which is in the form of an automatic machine, comprises means for driving the gripping assembly; towards and away from the insertion station, a fixed mandrel, and a shuttle having a parked position in which it is adjacent to one side of the mandrel, which side faces the insertion station, the mandrel, and the shuttle when in its parked position being straddable by the terminals with the tape positioned on the opposite side of the mandrel, the gripping assembly being arranged to grip each row of terminals against the shuttle when in its parked position and to entrain the shuttle, so as to carry the terminals and the shuttle towards the insertion station as the gripping assembly is moved theretowards by the driving means, thereby withdrawing the one ends of the terminals from the tape, the gripping assembly being arranged to release the terminals when their other ends have been inserted into the apertures in the workpiece, but to continue to entrain the shuttle to return it to its parked position.

According to another aspect of the invention apparatus as defined in the first paragraph of the present specification is characterised in that the apparatus, which is in the form of an automatic machine, comprises a housing; a gripping assembly slide mounted in the housing and being connected to the gripping assembly; means for driving the slide towards and away from the insertion station; a mandrel mounted fixedly with respect to the housing; a shuttle having a parked position in which it is adjacent to one side of the mandrel, which side faces the insertion station; and means for actuating the gripping assembly in response to the movement of the slide, the shuttle when in its parked position being straddable by the terminals with the tape positioned on the opposite side of the mandrel, and the actuating means being arranged to cause the gripping assembly to grip each row of terminals against the shuttle when in its parked position and to entrain the shuttle, so as to carry the terminals and the shuttle towards the insertion station as the slide is moved theretowards by the driving means, thereby withdrawing the one ends of the terminals from the tape, the actuating means being arranged to cause the gripping assembly to release the terminals when their other ends have been inserted into the apertures in the workpiece, but to continue to entrain the shuttle until it has been returned to its parked position, by return movement of the slide away from the insertion station.

According to a further aspect of the invention, a method of inserting into apertures in a workpiece at a terminal insertion station, electrical terminals depending in two spaced, juxtaposed rows from a flexible carrier tape, each terminal being detachably secured at one end to the tape, the method comprising the steps of releasably gripping the terminals and moving them towards the insertion station to insert the other end of each terminal in one of the apertures, the method also comprising the step of detaching the one end of each terminal from the tape; is characterised by the steps of gripping the terminals against opposite sides of a shuttle disposed between the two rows of terminals, with a mandrel disposed adjacent to the shuttle and between the shuttle and the tape; moving the shuttle away from the mandrel and towards the insertion station to withdraw the one ends of the terminals from the tape and to insert the other ends of the terminals into the apertures, releasing the terminals but continuing to engage the shuttle, and re-positioning the shuttle adjacent to the mandrel.

For a better understanding of the invention an embodiment thereof will now be described by way of example with reference to the accompanying drawings in which:—

Figure 1 is a vertical sectional side view of apparatus in the form of an automatic machine, for inserting tape mounted electrical terminals into apertures in a workpiece in the form of an electrical connector housing, the machine being shown in a rest condition prior to the tape being fed to a terminal gripping assembly of the machine;

Figure 1A is an enlarged, elevational view shown partly in section, of the gripping assembly when the tape has been fed thereto;

Figure 1B is an enlarged view taken on the lines IB—IB of Figure 1A;

Figure 2 is a similar view to that of Figure 1 but showing the gripping assembly closed about the tape;

Figure 2A is an enlarged partly sectional view, of the gripping assembly as shown in Figure 2;

Figure 2B is a view taken on the lines IIB—IIB of Figure 2A;

Figure 2C is an enlarged view of a fragment of Figure 2B;

Figure 3 is a vertical sectional side view showing the machine after the gripping assembly has carried out a working stroke to insert the terminals into the apertures;

Figure 3A is an enlarged partly sectional, view of the gripping assembly, the tape, the terminals and the housing, in the relative positions of Figure 3;

Figure 3B is a view taken on the lines IIIB—IIIB of Figure 3;

Figure 3C is a view taken on the lines IIIC—IIIC of Figure 3;

Figure 4 is a view similar to that of Figure 3 but showing the machine just prior to the return stroke of the gripping assembly;

Figure 4A is an enlarged view showing the gripping assembly, the tape, the terminals and the housing in the relative positions of Figure 4; and

Figure 5 is a view similar to that of Figure 1, but showing the machine during the return stroke of the gripping assembly.

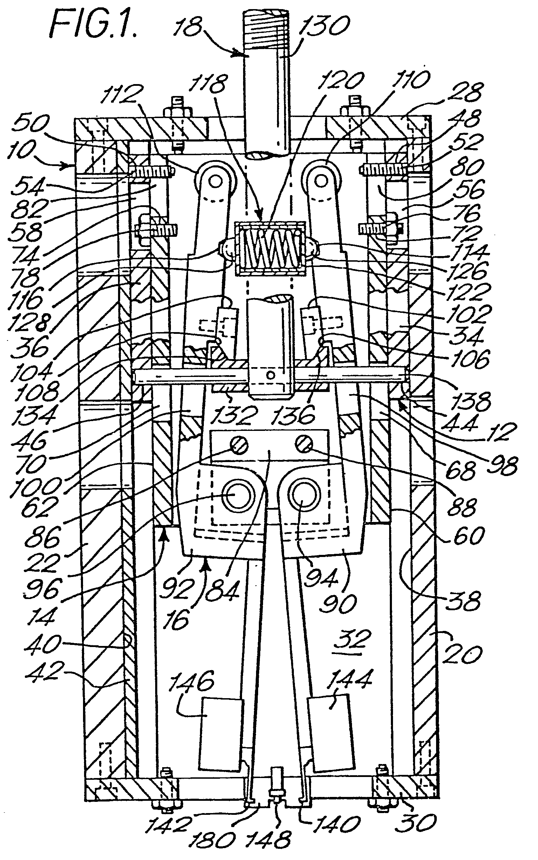

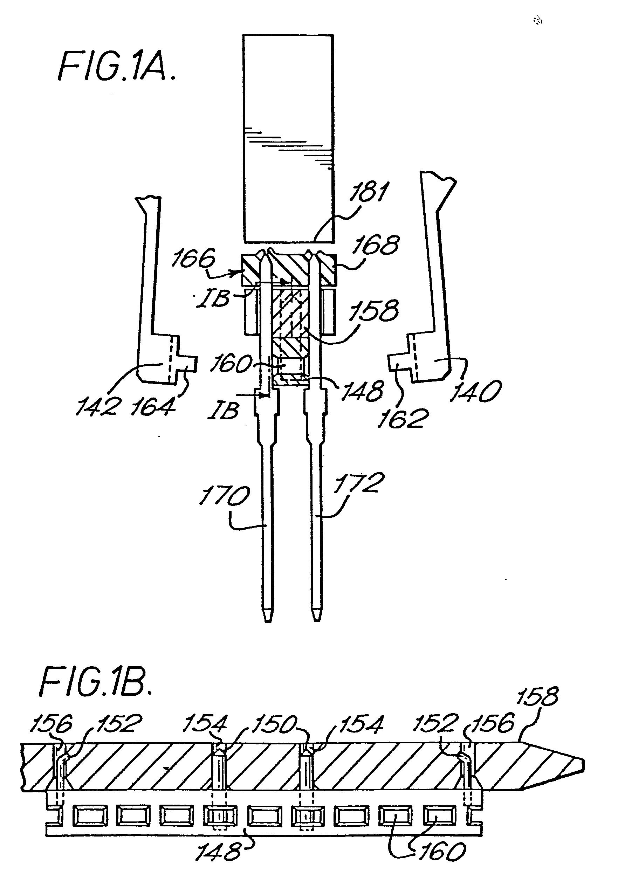

Reference will now be made to Figure 1. The machine comprises, a housing 10 having an outer slide 12 vertically slidably mounted therein, a box-like inner gripping assembly slide 14 being vertically slidable within the slide 12 and carrying a terminal gripping assembly 16. The slides 12 and 14 are arranged to be driven in vertical (as seen in Figure 1) reciprocating motion through drive means 18 by a conventional drive mechanism (not shown).

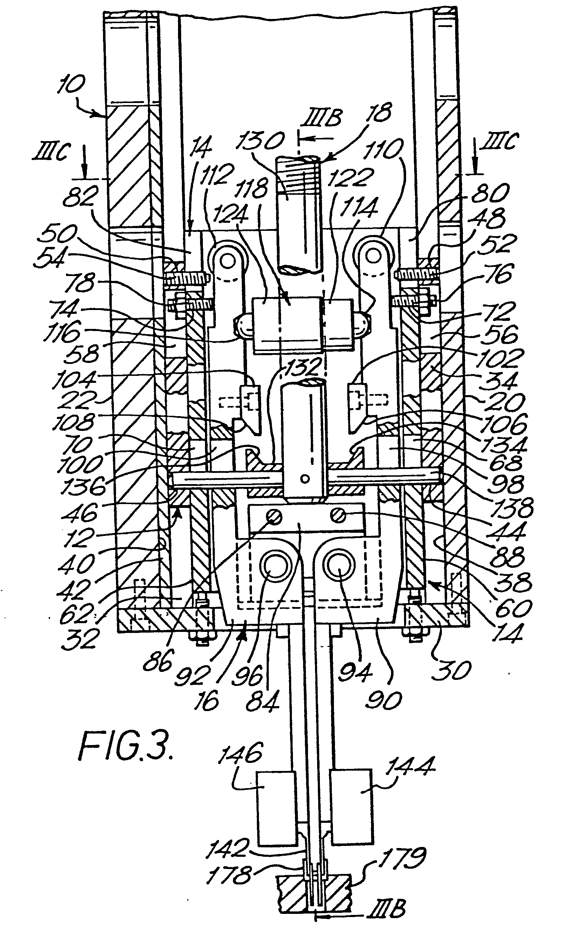

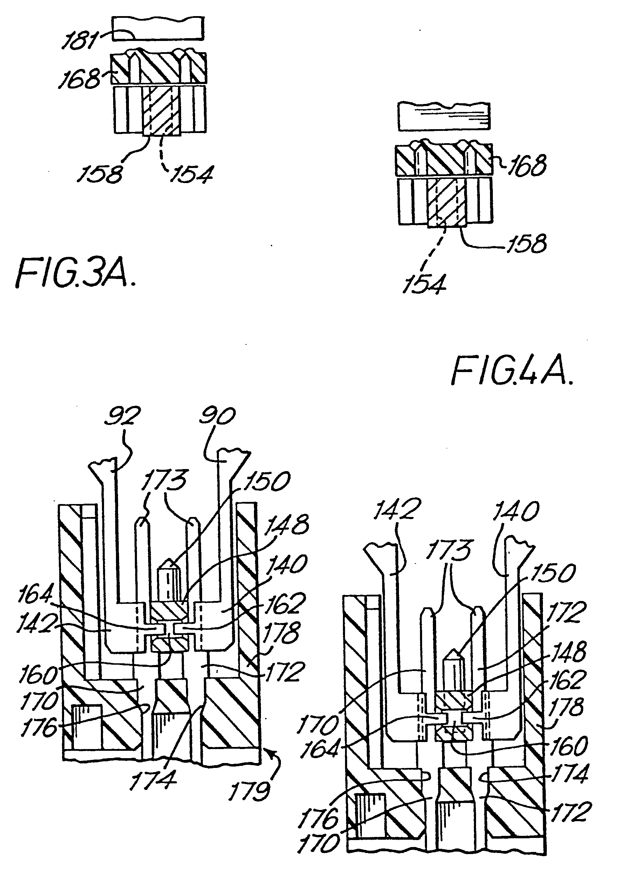

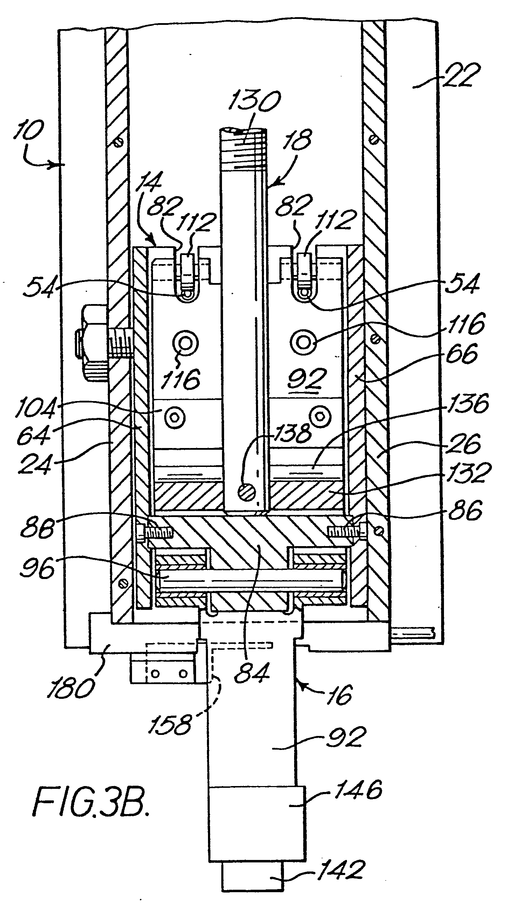

The housing 10 comprises a front plate 20, a rear plate 22, side plates 24 and 26 (Figures 3B and 3C), a top plate 28, and a bottom plate 30, all rigidly assembled together to form a substantially enclosed rectangular structure defining a cavity 32 therein receiving the slides 12 and 14. The outer slide 12 comprises a first slide plate 34 and a second slide plate 36, slidably mounted in a first channel 38 in the plate 20, and a second channel 40 in the plate 22, respectively, as will best be appreciated from Figure 3C. A single wear plate 42 between the plates 22 and 36, is shown in the second channel 40. Such a wear plate may be provided, as necessary, in one of, or, in both of, the channels 38 and 40 depending. upon the materials of which the plates 34 and 36 are formed. The slide plates 34 and 36 are provided with first pin holes 44 and 46, respectively, centrally disposed near their lower ends and second pin holes 48 and 50, respectively, disposed near their upper ends. The holes 48 and 50 receive guide pins 52 and 54, respectively, fixed therein, by means of the threads for example, as illustrated. The plates 34 and 36 are also provided with vertical slots 56 and 58, respectively, towards their upper ends adjacent to the guide pins 52 and 54.

The inner slide 14, which is substantially rectangular, has a front plate 60, a rear plate 62, and side plates 64 and 66 (as shown in Figures 3B and 3C). The plates 60 and 62 are provided with centrally located, vertical slots 68 and 70, respectively, towards their lower ends, and pin holes 72 and 74 towards their upper ends, receiving guide pins 76 and 78, respectively, which project into the slots 56 and 58, respectively. Vertically elongate pin notches 80 and 82 are provided in the upper edges of the plates 60 and 62 to receive the guide pins 52 and 54 on the plates 34 and 36, respectively.

The gripping assembly 16, which is mounted within the slide 14, comprises a pivot block 84 secured to the side plates 64 and 66, respectively, by pins 86, 88 (as shown in Figure 3B) and arms 90 and 92 pivotally mounted on the block 84 by means of pivot pins 94 and 96, respectively. The upper portions of the arms 90 and 92 have vertical, centrally disposed pin slots 98 and 100, respectively. Cam plates 102 and 104 secured to the arms 90 and 92, respectively, have downwardly directed planar cam surfaces 106 and 108, respectively, which are angled with respect to the longitudinal axes of the arms 90 and 92. The arms 90 and 92 are surmounted by cam wheels 110 and 112, respectively. Intermediate its cam plate 102 or 104 and its cam wheel 110 or 112, each arm 90 and 92 has a respective notch 114 or 116. A pair of spring bias means in the form of spring bias units 118 (Figure 3C), each comprising a compression spring 120 (Figure 1) contained in interfitting cylindrical housing members 122 and 124, are mounted between the arms 90 and 92 with knobs 126 and 128 on the distal ends of the members 122 and 124, engaged in the notches 114 and 116, respectively.

The drive means 18 comprises a plunger rod 130 which is vertically driven in the housing 10 by the conventional drive mechanism mentioned above. A cam block 132 fixed to the lower end of the plunger rod 130, has a pair of upwardly directed cam surfaces 134 and 136 which are complementary with, and are opposed to, the cam surfaces 106 and 108, respectively. A pivot pin 138 extends through the lower end of the plunger rod 130, through the cam block 132 through the slots 98 and 100 and through the slots 68 and 70 of the slide 14, and has its ends engaged in the holes 44 and 46 of the slide 12.

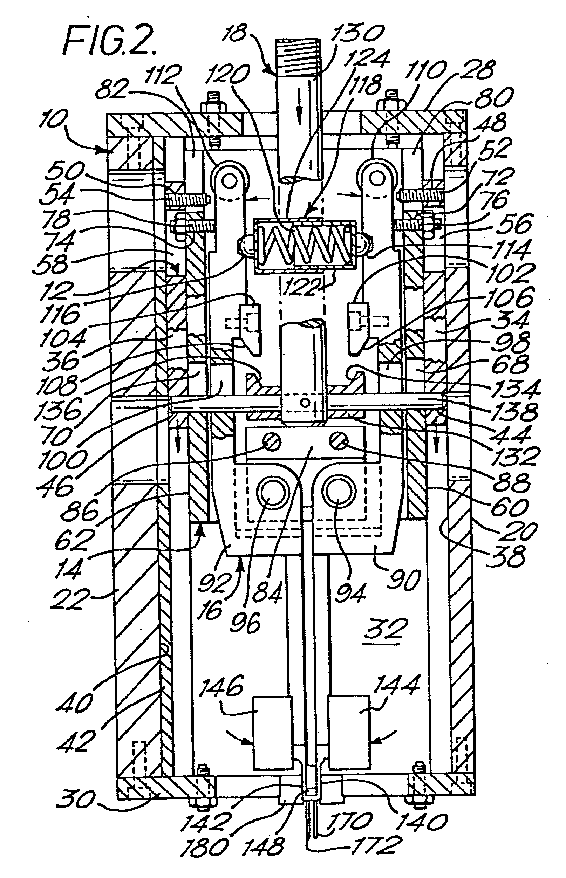

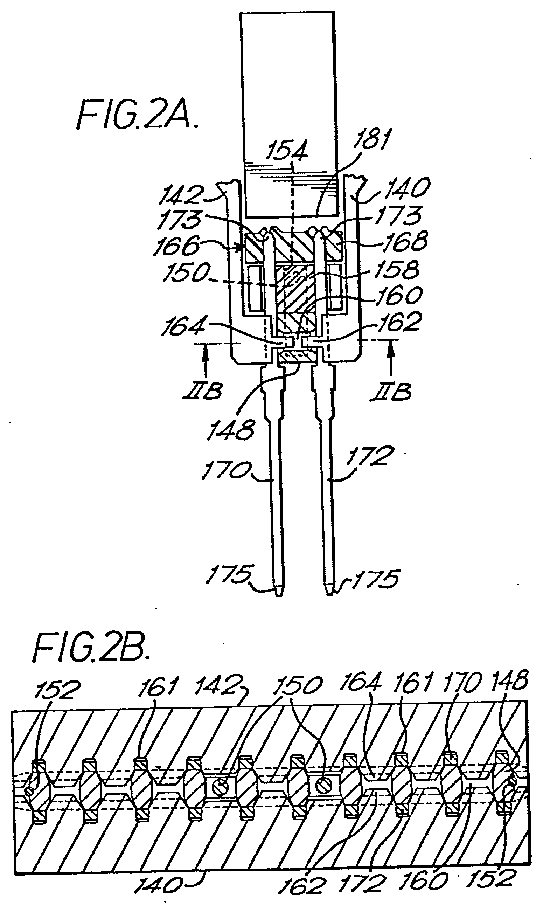

A pair of jaws 140 and 142 are connected to the lower ends of the arms 90 and 92, respectively, by jaw position adjustment assemblies 144 and 146, respectively. A shuttle 148 disposed between the jaws 140 and 142 is in the form of an elongate, substantially rectangular member having at least two alignment pins 150 (Figures 1B and 2B) extending from one side thereof, between spring pins 152 each extending from one end of such one side. The pins 150 and 152 engage, when the shuttle is parked (see Figure 1B) in respective apertures 154 and 156 in a blade portion of a mandrel 158, as shown in Figure 1B, detachably to secure the shuttle 148 against the mandrel 158. The mandrel 158 is shown in outline in Figure 3B. The shuttle 148 is also provided with a series of parallel, spaced, transverse aperturse 160 (best seen in Figure 1B), each of which is dimensioned to receive a tooth 162 or 164 (Figures 2A and 2B) of each of the jaws 140 and 142. The teeth 162 or 164 of each jaw 140 or 142 are distributed therealong in constantly spaced relationship, the spaces between these jaws being referenced 161.

A strip 166 of tape mounted terminals for use with the machine, best seen (in cross-section) in Figure 1A, comprises a flexible carrier tape 168 from which depends a plurality of electrical terminals 170 and 172 for insertion into pre-formed apertures 174 and 176, respectively, in a workpiece in the form of an electrical connector housing 178 (best seen in Figure 3A) positioned at an insertion station 179 below the plate 30. Each terminal 170 and 172, has one end 173 embedded in the tape 168 so that the terminal is detachably secured thereto its other end 175 being free although the terminals 170 and 172 are shown as being pin terminals, they may be any type of electrical terminal which can in practice be similarly applied to the carrier tape. The terminals depend in two juxtaposed, parallel rows from the tape 168, the terminals of one row being referenced 170 and those of the other being referenced 172. A similar strip of terminals is described in United States Patent Specification No. 3,545,606 for example.

The operation of the machine will now be described.

As shown in Figure 1, immediately prior to a cycle of operation of the machine, the slides 12 and 14 are in their uppermost positions. The plunger rod 130 is in its fully raised position so that the cam surfaces 134 and 136 of the cam block 132 fully engage the respective cam surfaces 106 and 108 of the cam plates 102 and 104 thereby holding the portions of the arms 90 and 92 which portions lie above the pivot pins 94 and 96 in their most proximate relative positions, so that the springs 120 are compressed and the jaws 140 and 142 are in an open position, as best seen in Figure 1A. The shuttle 148 is in its uppermost, parked, position, being retained adjacent to the mandrel 158 by engagement of the pins 150 and 152 on the shuttle 148 in their respective apertures 154 and 156 in the mandrel 158. In this parked position of the shuttle 148, each tooth 162 and 164 is aligned with an aperture 160 in the shuttle 148. A strip 166 of terminals 170 and 172 is now fed by means of a feed mechanism (not shown), through a strip guide 180 in the bottom plate 30 provided with an upper wall or roof 181, and along the top of the mandrel 158 so that the terminals 170 and 172 depend on opposite sides of, and thus straddle, the mandrel 158 and the shuttle 148 (Figure 1A). The strip 166 is fed a sufficient distance to insure that terminals 170 and 172 depend along the entire length of the shuttle 148.

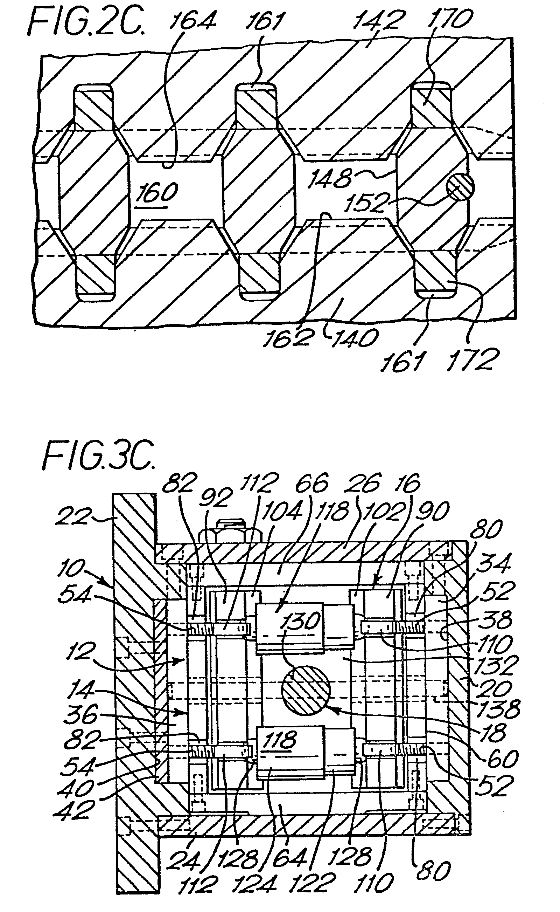

At the beginning of the cycle of operation, the plunger rod 130 is initially driven downwardly (Figure 2) through a working stroke to cause the following movements of the parts. The pin 138 on the rod 130 drives the slide 12 downwardly. Such movement of the pin 138 is not, however, immediately transmitted to the arms 90 and 92 or to the slide 14, by virtue of the elongate shape of the respective slots 98 and 100, and 68 and 70. During the downward movement of the rod 130 the cam block 132 thereon is also moved downwardly to disengage the cam surfaces 134 and 136 from the cam surfaces 106 and 108, so that the upper ends of the arms 90 and 92 are released from the position in which they are shown in Figure 1 and are pivoted away from one another under the action of the springs 120, to an extent limited by the pins 76 and 78, to cause the jaws 140 and 142 to grip both the rows of terminals 170 and 172 against the shuttle 148 as shown in Figures 2A and 2B. As shown in Figure 2B, the terminals 170 and 172 are held in the spaces 161 between the teeth 162 and 164 and against the adjacent sides of the shuttle 148.

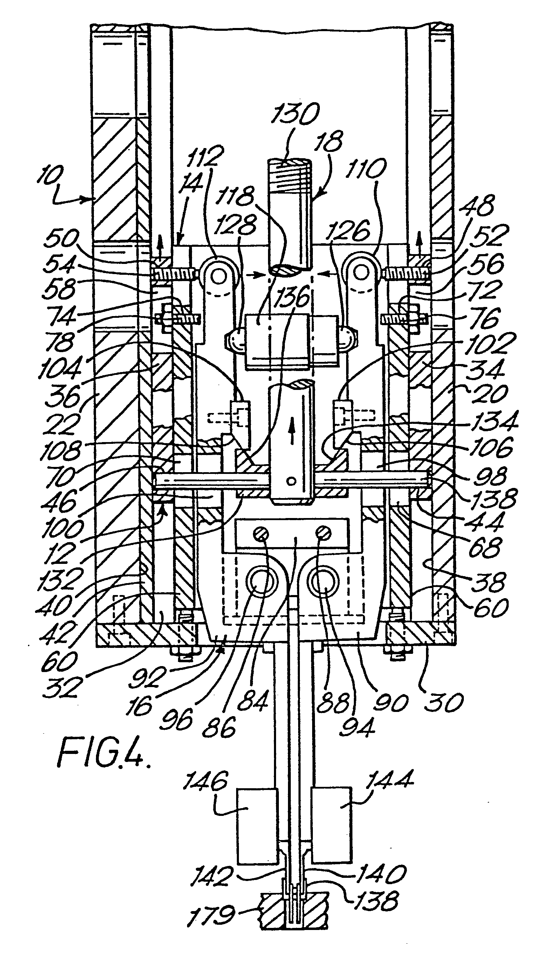

Continued descent of the rod 130 and the pins 138 and thus descent of gripping assembly 16, and the slide 14, when the pin 138 has reached the bottoms of the slots 68 and 70, and 98 and 100, causes the jaws 140 and 142 to entrain the shuttle 148 and the terminals so that the one ends 173 of the terminals are withdrawn from the tape 168 and the parts of the machine are brought to the position in which they are shown in Figure 3, in which the other ends 175 of the terminals 170 and 172 are fully inserted through the apertures 174, 176 of the housing 178 at the insertion station 179, as shown in detail in Figure 3A. The relative portions of the slides 12 and 14, are unchanged between the positions in which these parts are shown in Figures 2 and 3. Figures 3A and 4A (upper portions) show the tape 168 with the terminals withdrawn therefrom.

Figure 2C shows in detail, the configuration of the jaws 140 and 142 and the shuttle 148, and in particular the configuration of the recesses 161 in the jaws, to allow for the accommodation of terminals of various dimensions and tolerances without the need to exchange the jaws. The positions of the jaws relative to the arms 90 and 92 can be adjusted to take account of the terminal configuration by means of the adjustment assemblies 144 and 146.

As will appear from Figures 4 and 4A, the initial upward or return movement of the rod 130 causes the slide 12 to start to rise, the slide 14 and thus the assembly 16 remaining stationary by virtue of the lost motion connection provided between the slide 12, and the slide 14 and assembly 16, by virtue of the slots 68 and 70, and 98 and 100. As the rod 130 rises, the cam surfaces 134 and 136 initially partially engage the respective cam surfaces 106 and 108 (as shown in Figure 4), and the guide pins 52 and 54 simultaneously engage the respective cam rollers 110 and 112, so causing movement of the upper ends of the arms 90 and 92 slightly towards one another, against the action of the springs 120, partially to open the jaws 140 and 142 to release them from the inserted terminals 170 and 172 whilst still maintaining the jaws 140 and 142 in interference engagement with the shuttle 148 (Figure 4A).

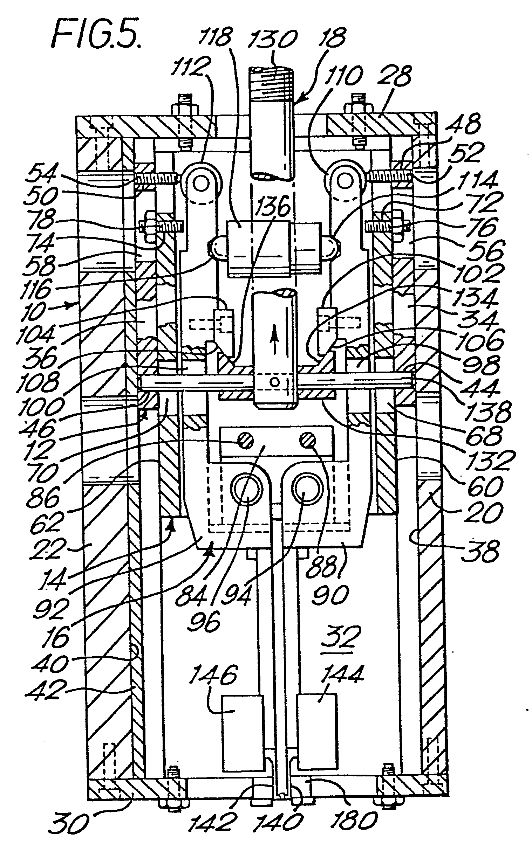

Continued ascent (Figure 5) of the rod 130 causes the slides 12 and 14 and the gripping assembly 16 to move upwardly, when the pin 138 has reached the tops of the slots 68 and 70, and 98 and 100 without the slides 12 and 14 changing their relative positions, the jaws 140 and 142 entraining the shuttle 148, until the shuttle 148 is again parked by engagement of the pins 150 and 152 on the shuttle 148, in their respective apertures 154 and 156 in the mandrel 158. Yet further ascent of the plunger rod 130 causes the cam surfaces 106 and 108, and 134 and 136, fully to engage, to cam the upper free ends of the pivot arms 90 and 92 inwardly, against the action of the springs 120, fully to open the jaws 140 and 142 to resume the position in which they are shown in Figure 1.

The feed mechanism again advances the strip 166, by a predetermined distance corresponding to the number of terminals to be inserted during the next cycle of operation of the machine.

The housing 178 may be positioned at the insertion station 179 either manually or by means of a further feed mechanism (not shown). The machine may be used to insert terminals into apertures in a circuit board or in some other suitable workpiece, instead of into apertures in an electrical terminal housing. Where rows of terminals are to be inserted into apertures in a workpiece and further rows of terminals are to be inserted on either side of or at either end of, the initially inserted rows of terminals, additional gripping assemblies (not shown) may be provided, or the workpiece may be fed stepwise along the insertion station, or both these expedients may be employed simultaneously.

The shuttle may be captive, being attached for example to one end of a lead spring (not shown), the other end of which is fixed, for example to the housing 10, the spring maintaining the shuttle in its parked position until the shuttle is entrained by jaws to move it towards the insertion station. The leaf spring may be employed to return the shuttle to its parked position.

**Claims**

1. Apparatus for inserting into apertures (174, 176) in a workpiece (178) at a terminal insertion station (179), electrical terminals (170, 172) depending in two spaced, juxtaposed rows from a flexible carrier tape (168), each terminal (170, 172) being detachably secured at one end (173) to the tape (168), the apparatus comprising an assembly (16) for releasably gripping the terminals (170, 172) and which can be moved towards the insertion station (179) to insert the other ends (175) of the terminals (170, 172) into the apertures (174, 176); characterised in that the apparatus, which is in the form of an automatic machine, comprises means (18) for driving the gripping assembly (16) towards and away from the insertion station (179), a fixed mandrel (158), and a shuttle (148) having a parked position in which it is adjacent to one side of the mandrel (158), which side faces the insertion station (179), the mandrel and the shuttle (148) when in its parked position being straddable by the terminals (170, 172) with the tape positioned on the opposite side of the mandrel (158), the gripping assembly (16) being arranged to grip each row of terminals (170, 172) against the shuttle when in its parked position and to entrain the shuttle (148), so as to carry the terminals (170, 172) and the shuttle (148) towards the insertion station (179) as the gripping assembly (16) is moved theretowards by the driving means (18), thereby withdrawing the one ends (173) of the terminals (170, 172) from the tape (168), the gripping assembly (16) being arranged to release the terminals (170, 172) when their other ends (175) have been inserted into the apertures (174, 176) in the workpiece (178), but to continue to entrain the shuttle (148) to return it to its parked position.

2. Apparatus according to Claim 1, characterised in that it comprises a housing (10), a gripping assembly slide (14) mounted in the housing (10) and being connected to the gripping assembly (16), means for driving the slide (14) towards and away from the insertion station (179), the mandrel (158) being mounted fixedly with respect to the housing (10), and means (102, 104, 118, 132) for actuating the gripping assembly (16) in response to the movement of the slide (14), the actuating means (52, 110, 102, 104, 134, 136) being arranged to cause the gripping assembly (16) to release the terminals (170, 172) when their other ends (175) have been inserted into the apertures (174, 176) in the workpiece (178), but to continue to entrain the shuttle (148) until it has been returned to its parked position, by return movement of the slide (14) away from the insertion station (179).

3. Apparatus according to Claim 2, characterised in that the driving means (18) is connected to the slide (14) by way of a lost motion connection (68, 70, 138) and carries a first cam (134, 136) co-operating with a second cam (102, 104) on the gripping assembly (16), to move gripping jaws (140, 142) of such assembly (16) between open, closed and partially closed, positions.

4. Apparatus according to Claim 2, characterised in that the gripping assembly slide (14) is mounted in a further slide (12) which is fixedly connected to the drive means (18) and is connected to the gripping assembly slide (14) through a lost motion connection (68, 138), the further slide (12) carrying cam means (52) co-operating with cam means (110) associated with jaws (140, 142) of the gripping assembly (16) to retain the jaws (140, 142) in a partially closed position during the return movement of the gripping assembly slide (14).

5. Apparatus according to Claim 2, characterised in that the gripping assembly (16) comprises a pair of pivotally mounted arms (90 and 92) each carrying a jaw (140, 142) and having cam rollers (110, 112) on their ends remote from the insertion station (179), a further slide (12), being arranged to be moved away from the insertion station (179) ahead of the gripping assembly slide (14), so that guide pins (52 and 54) on the further slide (12) cooperate with the rollers (110, 112), partially to open the jaws (140, 142) before the gripping assembly slide (14) is moved away from the insertion station (179).

6. Apparatus according to Claim 4 or 5, characterised in that the further slide (12) is slidable against a wear plate (42) disposed between the further slide (12) and the housing (10).

7. Apparatus according to Claim 4, 5 or 6, characterised in that gripping assembly slide (14) is in the form of an open ended, substantially rectangular box (60, 62, 64, 66), the further slide (12) comprising a pair of plates (34, 36) extending parallel to, and adjacent to, a pair of opposed sides (60 and 62) of the gripping assembly slide (14) and between such sides (60 and 62) and the housing (10), which is also in the form of a substantially rectangular box (20, 22, 24, 26).

8. Apparatus according to any one of the preceding Claims, characterised in that the shuttle (148) is detachably connected to the mandrel (158) in the parked position of the shuttle (148).

9. Apparatus according to any one of the preceding Claims, characterised in that the gripping assembly (16) has teeth (162, 164) engageable in apertures (160) in the shuttle (148).

10. A method of inserting into apertures (174, 176) in a workpiece (178) at a terminal insertion station (179), electrical terminals (170, 172) depending in two spaced, juxtaposed rows from a flexible carrier tape (168), each terminal (170, 172) being detachably secured at one end (173) to the tape (168), the method comprising the steps of releasably gripping the terminals (170, 172) and moving them towards the insertion station (179), to insert the other end (175) of each terminal (170, 172) in one of the apertures (174, 176), the method also comprising the step of detaching the one end of each terminal (170, 172) from the tape (168), characterised by the steps of gripping the terminals (170, 172) against opposite sides of a shuttle (148) disposed between the two rows of terminals (170, 172) with a mandrel (158) disposed adjacent to the shuttle (148) and between the shuttle (148) and the tape (168); moving the shuttle (148) away from the mandrel (158) and towards the insertion station (179) to withdraw the one ends of the terminals (170, 172) from the tape (168) and to insert the other ends of the terminals (170, 172) into the apertures (174, 176), releasing the terminals (170, 172) but continuing to engage the shuttle (148), and re-positioning the shuttle (148) adjacent to the mandrel (158).

**Patentansprüche**

1. Gerät zum Einsetzen von elektrischen Anschlüssen (170, 172), die in zwei beabstandeten, nebeneinander liegenden Reihen von einem flexiblen Trägerband (168) herabhängen, in Öffnungen (174, 176) in einem Werkstück (178) an einer Anschluß-Einsetzstation (179), wobei jeder Anschluß (170, 172) lösbar mit einem Ende (173) am Band (168) befestigt ist und das Gerät eine Anordnung (16) zum lösbaren Ergreifen der Anschlüsse (170, 172) umfaßt, die zur Einsetzstation (179) hinbewegbar ist, um die anderen Enden (175) der Anschlüsse (170, 172) in die Öffnungen (174, 176) einzusetzen, dadurch gekennzeichnet, daß das in Form einer automatischen Maschine vorliegende Gerät Einrichtungen (18) zum Antreiben der Greifanordnung (16) zur Einsetzstation (179) hin und von dieser weg umfaßt, sowie einen feststehenden Dorn (158) und ein Schiffchen (148), welches eine geparkte Stellung hat, in welcher es in der Nähe einer Seite des Dornes (158) steht, daß diese Seite der Einsetzstation (179) zugewandt ist, daß auf dem Dorn und dem Schiffchen (148), sofern es in seiner geparkten Stellung steht, die Anschlüsse (170, 172) rittlings angeordnet werden können, wobei das Band an der entgegengesetzten Seite des Dornes (158) angeordnet ist, daß die Greifanordnung (16) derart ausgebildet ist, daß sie jede Reihe von Anschlüssen (170, 172) gegen das Schiffchen greift, wenn dieses in seiner geparkten Position steht, und das Schiffchen (148) mitführt, so daß die Anschlüsse (170, 172) und das Schiffchen (148) zur Einsetzstation (179) getragen werden, während die Greifanordnung (16) dorthin durch die Antriebseinrichtung (18) bewegt wird, wodurch die einen Enden (173) der Anschlüsse (170, 172) von dem Band (168) abgezogen werden, daß die Greifanordnung (16) derart ausgebildet ist, daß die Anschlüsse (170, 172) freigegeben werden, wenn ihre anderen Enden (175) in die Öffnungen (174, 176) in dem Werkstück (178) eingesetzt wurden, daß jedoch die Mitführung des Schiffchens (148) fortgesetzt wird, um es in seine geparkte Stellung zurückzuführen.

2. Gerät nach Anspruch 1, dadurch gekennzeichnet, daß es ein Gehäuse (10) umfaßt, einen Greifanordnungsschlitten (14), der in dem Gehäuse (10) montiert ist und mit der Greifanordnung (16) verbunden ist, ferner Einrichtungen zum Antrieb des Schlittens (14) zur Einsetzstation (179) hin und von dieser weg, daß der Dorn (158) feststehend bezüglich des Gehäuses (10) angebracht ist, und daß Einrichtungen (102, 104, 118, 132) zur Betätigung der Greifanordnung (16) in Abhängigkeit von der Bewegung des Schlittens (14) vorgesehen sind, daß die Betätigungseinrichtungen (52, 110, 102, 104, 134, 136) derart angeordnet sind, daß sie die Greifanordnung (16) veranlassen, die Anschlüsse (170, 172) freizugeben, wenn deren andere Enden (175) in die Öffnungen (174, 176) in dem Werkstück (178) eingesetzt wurden, jedoch die Mitführung des Schiffchens (148) fortführen, bis es in seine geparkte Stellung zurückgeführt worden ist, und zwar durch die Rückkehrbewegung des Schlittens (14) von der Einsetzstation (179) weg.

3. Gerät nach Anspruch 2, dadurch gekennzeichnet, daß die Antriebseinrichtung (18) mit dem Schlitten (14) über eine Leerwegverbindung (68, 70, 138) verbunden ist und eine erste Nocke (134, 136) trägt, die mit einer zweiten Nocke (102, 104) auf der Greifanordnung (16) zusammenwirkt, um die Greifbacken (140, 142) dieser Anordnung (16) zwischen einer offenen, einer geschlossenen und einer teilweise geschlossenen Stellung zu bewegen.

4. Gerät nach Anspruch 2, dadurch gekennzeichnet, daß der Greifanordnungsschlitten (14) in einem weiteren Schlitten (12) angebracht ist, der fest mit der Antriebseinrichtung (18) verbunden ist und mit dem Greifanordnungsschlitten (14) über eine Leerwegverbindung (68, 138), daß der weitere Schlitten (12) Nockeneinrichtungen (52) trägt, die mit der den Backen (140, 142) der Greifanordnung (16) zugeordneten Nockeneinrichtung (110) zusammenwirkt, um die Backen (140, 142) während der Rückkehrbewegung des Greifanordnungsschlittens (14) in einer teilweise geschlossenen Stellung zu halten.

5. Gerät nach Anspruch 2, dadurch gekennzeichnet, daß die Greifanordnung (16) ein Paar von schwenkbar angebracht Armen (90 und 92) umfaßt, von denen jeder eine Backe (140, 142) trägt und Nockenrollen (110, 112) an ihren von der Einsetzstation (179) entfernten Armen tragen, daß ein weiterer Schlitten (12) derart angeordnet ist, daß er von der Einsetzstation (179) vor dem Greifanordnungsschlitten (14) wegbewegbar ist, so daß Führungsstifte (52 und 54) auf dem weiteren Schlitten (12) mit den Rollen (110, 112) zusammenwirken, um die Backen (140, 142) teilweise zu öffnen, bevor der Greifanordnungsschlitten (14) von der Einsetzstation (179) wegbewegt ist.

6. Gerät nach Anspruch 4 oder 5, dadurch gekennzeichnet, daß der weitere Schlitten (12) gleitend gegen eine Verschließplatte (42) angeordnet ist, die zwischen dem weiteren Schlitten (12) und dem Gehäuse (10) gelegen ist.

7. Gerät nach Anspruch 4, 5 oder 6, dadurch gekennzeichnet, daß der Greifanordnungsschlitten (14) die Form eines im wesentlichen rechteckigen Kastens (60, 62, 64, 66) mit offenem Ende aufweist, daß der weitere Schlitten (12) ein Paar von Platten (34, 36) umfaßt, die sich parallel zu und in der Nähe von einem Paar von entgegengesetzten Seiten (60 und 62) des Greifanordnungsschlittens (14) und zwischen diesen Seiten (60 und 62) und dem Gehäuse (10) erstrecken, das ebenfalls in der Form eines im wesentlichen rechteckigen Kastens (20, 22, 24, 26) vorliegt.

8. Gerät nach einem der vorhergehenden Ansprüche, dadurch gekennzeichnet, daß das Schiffchen (148) lösbar mit dem Dorn (158) in der geparkten Stellung des Schiffchens (148) verbunden ist.

9. Gerät nach einem der vorhergehenden Ansprüche, dadurch gekennzeichnet, daß die Greifanordnung (16) Zähne (162, 164) aufweist, die in Öffnungen (160) in dem Schiffchen (148) eingreifen können.

10. Verfahren zum Einsetzten elektrischer Anschlüsse (170, 172), die in zwei beabstandeten, nebeneinanderliegenden Reihen von einem flexiblen Trägerband (168) herabhängen, in Öffnungen (174, 176) in einem Werkstück (178) an einer Anschlußeinsetzstation (179), wobei jeder Anschluß (170, 172) lösbar mit einem Ende (173) an dem Band (168) befestigt ist, und wobei in diesem Verfahren die Anschlüsse (170, 172) lösbar ergriffen und zur Einsetzstation (179) hinbewegt werden, um das andere Ende (175) jedes Anschlusses (170, 172) in eine der Öffnungen (174, 176) einzusetzen, und wobei schließlich das eine Ende jedes Anschlusses (170, 172) von dem Band (168) gelöst wird, dadurch gekennzeichnet, daß die Anschlüsse (170, 172) gegen entgegengesetzte Seiten eines Schiffchens (148) ergriffen werden, das zwischen den beiden Reihen von Anschlüssen (170, 172) angeordnet ist, wobei ein Dorn (158) benachbart zum Schiffchen (148) und zwischen dem Schiffchen (148) und dem Band (168) angeordnet ist, daß das Schiffchen (148) von dem Dorn (158) weg zur Einsetzstation (179) bewegt wird, um die einen Enden der Anschlüsse (170, 172) von dem Band (168) abzuziehen und die anderen Enden der Anschlüsse (170, 172) in die Öffnungen (174, 176) einzusetzen, daß die Anschlüsse (170, 172) freigegeben werden, jedoch weiter mit dem Schiffchen (148) in Eingriff stehen, und daß das Schiffchen (148) in die Nachbarschaft des Dornes (158) zurückpositioniert wird.

**Revendications**

1. Appareil pour insérer, dans des ouvertures (174, 176) d'une pièce (178) dans un poste (179) d'insertion de bornes, des bornes électriques (170, 172) dépassant vers le bas, en deux rangées juxtaposées et espacées, d'un ruban porteur flexible (168), chaque borne (170, 172) étant reliée de manière détachable par une première extrémité (173) au ruban (168), l'appareil comprenant un ensemble (16) destiné à prendre de manière amovible les bornes (170 et 172) et qui peut être déplacé vers le poste d'insertion (179) pour insérer les autres extrémités (175) des bornes (170, 172) dans les ouvertures (174, 176); caractérisé en ce que l'appareil qui se présente sous la forme d'une machine automatique, comprend des moyens (18) d'entraînement pour rapprocher et éloigner l'ensemble (16) de préhension du poste (179) d'insertion, un mandrin fixe (158), et une navette (148) ayant une position d'attente dans laquelle elle est adjacente à un premier côté du mandrin (158), lequel côté fait face au poste d'insertion (179), le mandrin et la navette (148), lorsqu'elle est dans sa position d'attente, étant chevauchés par les bornes (170, 172), le ruban étant positionné sur le côté opposé du mandrin (158), l'ensemble (16) de préhension étant agencé pour serrer chacune des rangées de bornes (170, 172) contre la navette lorsqu'elle est dans sa position d'attente et pour entraîner la navette (148), afin de transporter les bornes (170, 172) et la navette (148) vers le poste d'insertion (179) lorsque l'ensemble de préhension (16) est déplacé vers celui-ci par les moyens d'entraînement (18), retirant ainsi les premières extrémités (173) des bornes (170, 172) du ruban (168), l'ensemble (16) de préhension étant agencé pour libérer les bornes (170, 172) lorsque leurs autres extrémités (175) ont été insérées dans les ouvertures (174, 176) de la pièce (178), mais pour continuer à entraîner la navette (148) afin de la ramener dans sa position d'attente.

2. Appareil selon la revendication 1, caractérisé en ce qu'il comporte un corps (10), un coulisseau (14) d'ensemble de préhension monté dans le corps (10) et relié à l'ensemble (16) de préhension, des moyens d'entraînement destinés à rapprocher et éloigner le coulisseau (14) du poste (179) d'insertion, le mandrin (158) étant monté fixement par rapport au corps (10), et des moyens (102, 104, 118, 132) pour actionner l'ensemble (16) de préhension en réponse au mouvement du coulisseau (14), les moyens d'actionnement (52, 110, 102, 104, 134, 136) étant agencés pour agir sur l'ensemble (16) de préhension afin qu'il libère les bornes (170, 172) lorsque leurs autres extrémités (175) ont été insérées dans les ouvertures (174, 176) de la pièce (178), mais pou qu'il continue à entraîner la navette (148) jusqu'à ce qu'elle ait été ramenée dans sa position d'attente, par un mouvement de retour du coulisseau (14) s'éloignant du poste (179) d'insertion.

3. Appareil selon la revendication 2, caractérisé en ce que les moyens d'entraînement (18) sont reliés au coulisseau (14) à l'aide d'une liaison à chemin perdu (68, 70, 138) et portent une première came (134, 136) coopérant avec une seconde came (102, 104) située sur l'ensemble (16) de préhension,a fin de déplacer des mâchoires de préhension (140, 142) de cet ensemble (16) entre des positions d'ouverture, de fermeture et de fermeture partielle.

4. Appareil selon la revendication 2, caractérisé en ce que le coulisseau (14) de l'ensemble de préhension est monté dans un autre coulisseau (12) qui est relié fixement aux moyens (18) d'entraînement et qui est relié au coulisseau (14) de l'ensemble de préhension par une liaison à chemin perdu (68, 138), l'autre coulisseau (12) portant des moyens de came (52) coopérant avec des moyens de came (110) associés aux mâchoires (140, 142) de l'ensemble (16) de préhension pour retenir les mâchoires (140, 142) dans une position de fermeture partielle pendant le mouvement de retour du coulisseau (14) de l'ensemble de préhension.

5. Appareil selon la revendication 2, caractérisé en ce que l'ensemble (16) de préhension comprend deux bras (90 et 92) montés de façon à pouvoir pivoter, portant chacun une mâchoire (140, 142) et ayant des galets de came (110, 112) sur leurs extrémités éloignées du poste (179) d'insertion, un autre coulisseau (12) étant agencé de manière à être éloigné du poste (179) d'insertion, en avant du coulisseau (14) de l'ensemble de préhension, de manière que des broches de guidage (52 et 54) situées sur l'autre coulisseau (12) coopèrent avec les galets (110, 112) pour ouvrir partiellement les mâchoires (140, 142) avant que le coulisseau (14) de l'ensemble de préhension s'éloigne du poste (179) d'insertion.

6. Appareil selon la revendication 4 ou 5, caractérisé en ce que l'autre coulisseau (12) peut coulisser contre une plaque d'usure (42) disposée entre l'autre coulisseau (12) et le corps (10).

7. Appareil selon la revendication 4, 5 ou 6, caractérisé en ce que le coulisseau (14) de l'ensemble de préhension se présente sous la forme d'un boîtier sensiblement rectangulaire (60, 62, 64, 66), ouvert à ses extrémités, l'autre coulisseau (12) comprenant deux plaques (34, 36) s'étendant parallèlement et de façon adjacente à deux côtés opposés (60 et 62) du coulisseau (14) de l'ensemble de préhension et entre ces côtés (60 et 62) et le corps (10), qui se présente également sous la forme d'une boîte sensiblement rectangulaire (20, 22, 24, 26).

8. Appareil selon l'une quelconque des revendications précédentes, caractérisé en ce que la navette (148) est reliée de manière amovible au mandrin (158) dans la position d'attente de la navette (148).

9. Appareil selon l'une quelconque des revendications précédentes, caractérisé en ce que l'ensemble (16) de préhension comporte des dents (162, 164) pouvant s'engager dans des ouvertures (160) de la navette (148).

10. Procédé d'insertion, dans des ouvertures (174, 176) d'une pièce (178) dans un poste (179) d'insertion de bornes, de bornes électriques (170, 172) qui dépassent vers le bas, en deux rangées juxtaposées et espacées, d'un ruban porteur flexible (168), chaque borne (170, 172) étant reliée de manière amovible par une première extrémité (173) au ruban (168), le procédé comprenant les étapes qui consistent à prendre de manière amovible les bornes (170, 172) et à les déplacer vers le poste d'insertion (179), à insérer l'autre extrémité (175) de chaque borne (170, 172) dans l'une des ouvertures (174, 176), le procédé comprenant également l'étape qui consiste à détacher la première extrémité de chaque borne (170, 172) du ruban (168), caractérisé par les étapes qui consistent à serrer les bornes (170, 172) contre des côtés opposés d'une navette (148) disposée entre les deux rangées de bornes (170, 172), un mandrin (158) étant disposé à proximité immédiate de la navette (148) et entre la navette (148) et le ruban (168); à éloigner la navette (148) du mandrin (158) et à la rapprocher du poste (179) d'insertion pour retirer les premières extrémités des bornes (170, 172) du ruban (168) et insérer les autres extrémités des bornes (170, 172) dans les ouvertures (174, 176), à libérer les bornes (170, 172) mais à continuer la prise sur la navette (148), et à repositionner la navette (148) à proximité immédiate du mandrin (158).

FIG.1.

1

FIG.1A.

FIG.1B.

FIG.2.

0 0 19 396

FIG.2A.

FIG.2B.

4

FIG.2C.

164  161          142  170

160        148
              152

162  140
         161  172

FIG.3C.

22

82  92  112  66  26  16
        104  118  102  90
10
54                        80
                          34
                          52
12                        38
                          110
14            130         132
36            118         20
82                        138
54                        18
40                        60
42                        52

24  128  64  128  80
112  124  122  110

**0019396**

FIG.3.

6

0019396

FIG.3A.

FIG.4A.

7

FIG.3B.

FIG.4.

0 019 396

9

FIG.5.